# EUROPEAN PATENT SPECIFICATION

(11) **EP 1 394 612 B1**
(45) Date of publication and mention of the grant of the patent: **08.10.2008**
(21) Application number: 03077675.1
(22) Date of filing: 25.08.2003
(51) Int. Cl.: G03F 7/20

(54) **Lithographic projection apparatus and reflector assembly for use in said apparatus**
Lithographischer Projektionsapparat und Reflektoranordnung für die Verwendung in diesem Apparat
Appareil de projection lithographique et ensemble réflecteur pour l'emploi dans cet appareil

(30) Priority: 27.08.2002 EP 02078528
(43) Date of publication of application: 03.03.2004
(73) Proprietor: ASML Netherlands B.V., 5504 DR Veldhoven (NL)
(72) Inventor: Schuurmans, Frank Jeroen Pieter, 5551 XE Valkenswaard (NL); Bakker, Levinus Pieter, 5708 ZT Helmond (NL)
(74) Representative: van Westenbrugge, Andries

(56) References cited:
- EP-A- 0 955 565
- EP-A- 1 037 510
- WO-A-02/065482
- US-A- 4 206 494
- US-A- 5 768 339
- US-B1- 6 285 737
- HERBERT L. ANDERSON: "Physics Vade Mecum" 1981, AMERICAN INSTITUTE OF PHYSICS , USA , XP002300703 * page 254; figure B *

## Description

The invention relates to a lithographic projection apparatus comprising:
- an illumination system with a radiation source, to form a projection beam of radiation,
- a support structure constructed to hold patterning means, to be irradiated by the projection beam to pattern said projection beam,
- a substrate table constructed to hold a substrate, and
- a projection system constructed and arranged to image an irradiated portion of the patterning means onto a target portion of the substrate,
wherein a reflector assembly is placed in the vicinity of the source or an image of the source, the reflector assembly comprising at least an inner and an outer reflector extending in the direction of an optical axis on which the source or an image of the source is located, the inner reflector being closer than the outer reflector to the optical axis, the reflectors each having an inner reflective surface and an outer backing layer.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required; and
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In a lithographic apparatus the size of features that can be imagined onto the substrate is limited by the wavelength of the projection radiation. To produce integrated circuits with a higher density of devices, and hence higher operating speeds, it is desirable to be able to image smaller features. Whilst most current lithographic projection apparatus employ ultraviolet light generated by mercury lamps or excimer lasers, it has been proposed to use shorter wavelength radiation in the range 5 to 20 nm, especially around 13 nm. Such radiation is termed extreme ultraviolet (EUV) or soft x-ray and possible sources include, for instance, laser-produced plasma sources,
discharge plasma sources, or synchrotron radiation from electron storage rings. Apparatus using discharge plasma sources are described in: W. Partlo, I. Fomenkov, R. Oliver, D. Birx, "Development of an EUV (13.5 nm) Light Source Employing a Dense Plasma Focus in Lithium Vapor", Proc. SPIE 3997, pp. 136-156 (2000); M.W. McGeoch, "Power Scaling of a Z-pinch Extreme Ultraviolet Source", Proc. SPIE 3997, pp. 861-866 (2000); W.T. Silfvast, M. Klosner, G. Shimkaveg, H. Bender, G. Kubiak, N. Fornaciari, "High-Power Plasma Discharge Source at 13.5 and 11.4 nm for EUV lithography", Proc. SPIE 3676, pp. 272-275 (1999); and K. Bergmann et al., "Highly Repetitive, Extreme Ultraviolet Radiation Source Based on a Gas-Discharge Plasma", Applied Optics, Vol. 38, pp. 5413-5417 (1999).

EUV radiation sources may require the use of a rather high partial pressure of a gas or vapor to emit EUV radiation, such as discharge plasma radiation sources referred to above. In a discharge plasma source, for instance, a discharge is created in between electrodes, and a resulting partially ionized plasma may subsequently be caused to collapse to yield a very hot plasma that emits radiation in the EUV range. The very hot plasma is quite often created in Xe, since a Xe plasma radiates in the Extreme UV (EUV) range around 13.5 nm. For an efficient EUV production, a typical pressure of 0.1 mbar is required near the electrodes to the radiation source. A drawback of having such a rather high Xe pressure is that Xe gas absorbs EUV radiation. For example, 0.1 mbar Xe transmits over 1 m only 0.3 % EUV radiation having a wavelength of 13.5 nm. It is therefore required to confine the rather high Xe pressure to a limited region around the source. To reach this the source can be contained in its own vacuum chamber that is separated by a chamber wall from a subsequent vacuum chamber in which the collector mirror and illumination optics may be obtained.

European patent application 1 037 510 describes a high energy photon source that can be used with a lithographic projection apparatus. The radiation produced is captured with collection optics, i.e. a collector, that captures the radiation and directs it towards the lithographic apparatus.

American patent 6,285,737 describes a condenser for use with a ring-field camera in a projection lithographic apparatus. The condenser system comprises quasi grazing-incidence collector mirrors that are coated with a suitable reflective metal.

American patent 5,768,339 describes a collimator for x-rays comprising several reflectors. The geometry of the collimator tube is such that its entrance aperture is of a smaller diameter than its exit aperture.

American patent 4,206,494 describes a high throughput illuminator in which a relatively high percentage of the light given off by a source lamp is gathered by four collector lens systems disposed around the lamp.

European patent application 0 955 565 describes a mirror for use in a soft x-ray exposure apparatus. The mirror includes a metal substrate and a thin film of an amorphous material thereon, the latter being polished to optical smoothness.

WO 02/065482 discloses a reflector assembly comprising a cooling device located on the back surface of the reflectors.

Thermal radiation emanating from, among others, the EUV source and the foil trap in a lithographic projection apparatus results in heating of the objects on which it impinges. In a lithographic projection apparatus these objects will generally be the optical components which make up the apparatus. An example of an optical component placed in the vicinity of the source, may be formed by a set of reflectors which function as a collector for light emanating from the source. Heating up of the collector due to this thermal radiation leads to expansion of parts in the collector causing geometrical aberrations of the collector and, ultimately, leads to its destruction.
It is therefore an object of the invention to provide a lithographic projection apparatus with a reflective element, in particular a collector, for which the radiative heat load is reduced.

It is another object of the invention to provide a lithographic projection apparatus with a reflective element, in particular a collector, that is effectively cooled.
It is yet another object of the invention to provide a collector with a relatively long life span.

This and other objects are achieved according to the present invention in a lithographic apparatus as specified in the opening paragraph, wherein . the backing layer of the inner reflector is covered with a reflective layer having a reflectivity of between 0,7 and 0,99 preferably between 0,8 and 0,99 for wavelengths between 0,1 and 100 µm, preferably between 1 and 10 µm.
Thus, the reflector assembly will reflect a substantial amount of the infrared radiation that impinges upon the back of the reflector, which will reduce the heat load on the reflector assembly.

In another embodiment of the invention, a reflector assembly is placed in the vicinity of the source or an image of said source, the reflector assembly comprising at least an inner and an outer reflector extending in the direction of an optical axis on which the source or an image of said source is located, the inner reflector being closer to the optical axis than the outer reflector, the reflectors each having an inner reflective surface and an outer backing layer, the backing layer of the outer reflector being covered with a radiative layer having an emissivity of typically 0,8 for wavelengths between 1 and 10 µm. By providing the backing layer of the outer reflector with relatively strong infrared radiation emitting properties, this has as an advantage that increased amounts of radiation are emitted by the reflector assembly resulting in improved radiation cooling.
In yet another embodiment of the invention a reflector assembly is placed in the vicinity of the source or an image of said source, the reflector assembly comprising at least an inner and an outer reflector extending in the direction of an optical axis on which the source or an image of said source is located, the inner reflector being closer to the optical axis than the outer reflector, the reflectors each having an inner reflective surface and an outer backing layer, the backing layer of the outer reflector being covered with a radiative layer having an emissivity of typically 0,8 for wavelengthsbetween 1 and 10 µm and the backing layer of the inner reflector is covered with a reflective layer having a reflectivity of typically 0,9 or more for wavelengths between 1 and 10 µm. This has as an advantage that the reflector assembly has both a reflective coating on the backing layer of the inner reflectors and a radiative coating on the backing of the outermost reflector, for both reducing the absorbed heat radiation and increasing the emitted heat radiation.

The reflective layer may be made of a noble metal such as for instance gold or ruthenium. The radiative layer may be made of carbon for optimal heat load reductive properties.

Each reflector may comprise at least two adjacent reflecting surfaces, the reflecting surfaces further from the source being placed at smaller angles to the optical axis than the reflecting surface that is closer to the source. In this way, a grazing incidence collector is constructed for generating a beam of UV radiation propagating along the optical axis. Preferably, at least two reflectors are placed substantially coaxially and extend substantially rotationally symmetric around the optical axis. A grazing incidence collector of this (Wolter-) type is, for instance, described in German patent application no. DE 101 38 284.7. The collector which results can be used as an (E)UV radiation focusing device in a lithographic projection apparatus.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.
In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:
Fig. 1 schematically depicts a lithographic projection apparatus according to an embodiment of the invention;
Fig. 2. shows a side view of an EUV illuminating system and projection optics of a lithographic projection apparatus according to the invention;
Fig. 3 shows a detail of the radiation source and grazing incidence collector of the present invention;
Fig. 4 shows an axial cross-sectional view of a collector layout according to the invention;
Fig. 5 shows a perspective side view of an embodiment of the collector equipped with radiation fins;
Fig. 6 shows a schematic view of a lithographic projection apparatus having two differential pressure chambers and
Fig. 7 is a detailed view of the structure of a foil trap.

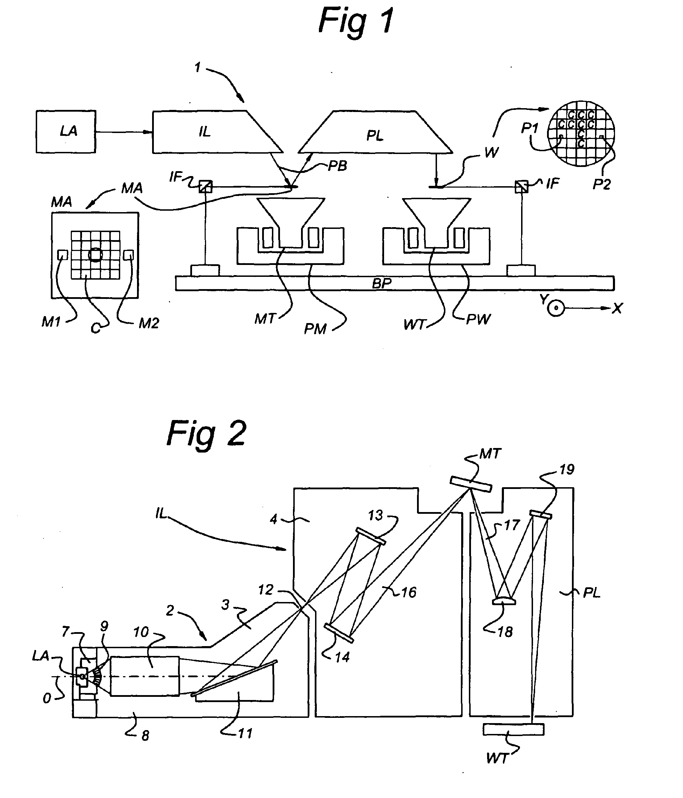

Fig. 1 schematically depicts a lithographic projection apparatus 1 according to a particular embodiment of the invention. The apparatus comprises:
- a radiation system Ex, IL, for supplying a projection beam PB of radiation (e.g. EUV radiation with a wavelength of 11-14 nm). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W. As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source LA (e.g. a laser-produced plasma or a discharge plasma EUV radiation source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Fig. 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or ydirections so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed *v*, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Fig. 2 shows the projection apparatus 1 comprising an illumination system IL with radiation unit 3, illumination optics unit 4, and projection optics system PL. The radiation system 2 comprises a source-collector module or radiation unit 3 and an illumination optics unit 4. Radiation unit 3 is provided with a radiation source LA which may be formed by a discharge plasma. EUV radiation source 6 may employ a gas or vapor, such as Xe gas or Li vapor in which a very hot plasma may be created to emit radiation in the EUV range of the electromagnetic spectrum. The very hot plasma is created by causing a partially ionized plasma of an electrical discharge to collapse onto the optical axis O. Partial pressures of 0.1 mbar of Xe, Li vapor or any other suitable gas or vapor may be required for efficient generation of the radiation. The radiation emitted by radiation source LA is passed from the source chamber 7 into collector chamber 8 via a gas barrier structure or "foil trap" 9. The gas barrier structure comprises a channel structure such as, for instance, described in detail in European patent applications EP-A-1 223 468 and EP-A-1 057 079.

The collector chamber 8 comprises a radiation collector 10 which according to the present invention is formed by a grazing incidence collector. Radiation passed by collector 10 is reflected off a grating spectral filter 11 to be focused in a virtual source point 12 at an aperture in the collector chamber 8. From chamber 8, the projection beam 16 is reflected in illumination optics unit 4 via normal incidence reflectors 13, 14 onto a reticle or mask positioned on reticle or mask table MT. A patterned beam 17 is formed which is imaged in projection optics system PL via reflective elements 18, 19 onto wafer stage or substrate table WT. More elements than shown may generally be present in illumination optics unit 4 and projection system PL.

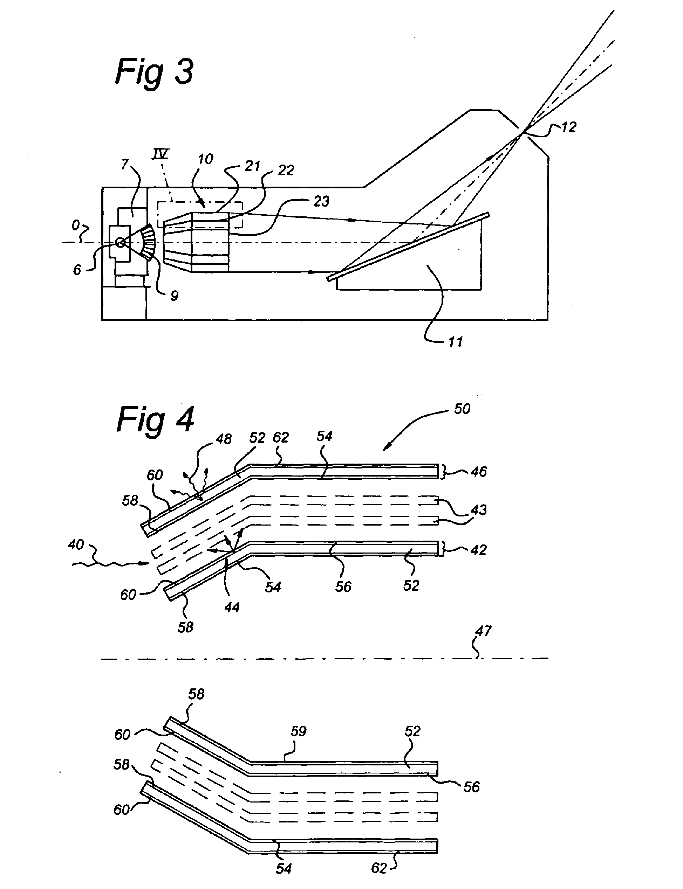

As can be seen in Fig. 3, the grazing incidence collector 10 comprises a number of nested reflector elements 21, 22, 23. A grazing incidence collector of this type is, for instance, shown in German patent application DE 101 38 284.7.

As indicated in Fig 4, the infrared radiation 40 impinges on a collector 50 which is aligned along an optical axis 47. The collector 50 may comprise several reflectors 42, 43, 46. An example of such a collector is shown in Fig 3 with reference numeral 10. In Fig 4, the inner reflector is indicated by reference numeral 42, the outer reflector is indicated by reference numeral 46. In between the reflectors 42 and 46 several other reflectors 43 may be located, the outlines of which are shown in Fig 4 with dashed lines. All the reflectors 42 and 43 are coated on their backing layer 52 with a heat/infrared radiation reflecting layer 56, such that infrared radiation 40 on these reflectors is reflected as indicated by the arrows 44. The outer reflector 46 has on its backing layer 52 a radiative coating 62. The arrows 48 in Fig 4 indicate heat/infrared radiation.

In Fig 4 further the detailed composition of the inner reflector 42 of the collector 50 is illustrated. The reflector 42 comprises a backing layer 52 made of material that gives the reflector 24 its mechanical strength e.g. nickel (Ni) of thickness 0,5 to 1 mm. The reflectors 42 ,43 and 46 comprise a (E)UV reflecting side, in fig 4, as an example, shown comprising of two parts 58 and 59. On the (E)UV mirroring side 58 of the reflector 42 a coating 54 is added of a material that will give the reflector its requested (E)UV reflecting properties, such as gold for instance (Au) or ruthenium (Ru) of thicknesses in the range of approximately 50 nanometers to several microns. According to the present invention the manufacturing process of depositing a noble metal layer 54 as an (E)UV reflective layer is extended in that on the side 60 of the backing layer 52 a further coating 56 such as for instance gold of thickness such that in can be considered as infinitely thick for the infrared radiation, i.e. approximately several microns, or another infrared radiation reflecting material, is added, by known techniques such as for instance chemical vapor or electrochemical deposition. Coating 56 is substantially reflecting for heat/infrared radiation, which results in less heat/infrared absorption of the backing layer 52.

In Fig 4 also the detailed composition of the outer reflector 46 is illustrated. Instead of a heat/infrared mirroring layer 56 that covers the backing layer 52 as is the case for the inner layers 42, 43, the backing layer 52 of the outer reflector 46 is covered on the outside 60 with a heat/infrared radiative layer 62 made of for instance carbon (C) several microns thick or any other heat/infrared radiative material known to the skilled person. The carbon coating will enhance the "black body" emissivity of the outermost reflector 46 and hence of the entire collector 50.

The mirroring side 58 of the reflectors 42, 43 and 46 in fig. 4 in reality can be curved. It may be comprise two joining segments one of which is shaped as the segment of a hyperbola and one of which is shaped as a ellipsoid.

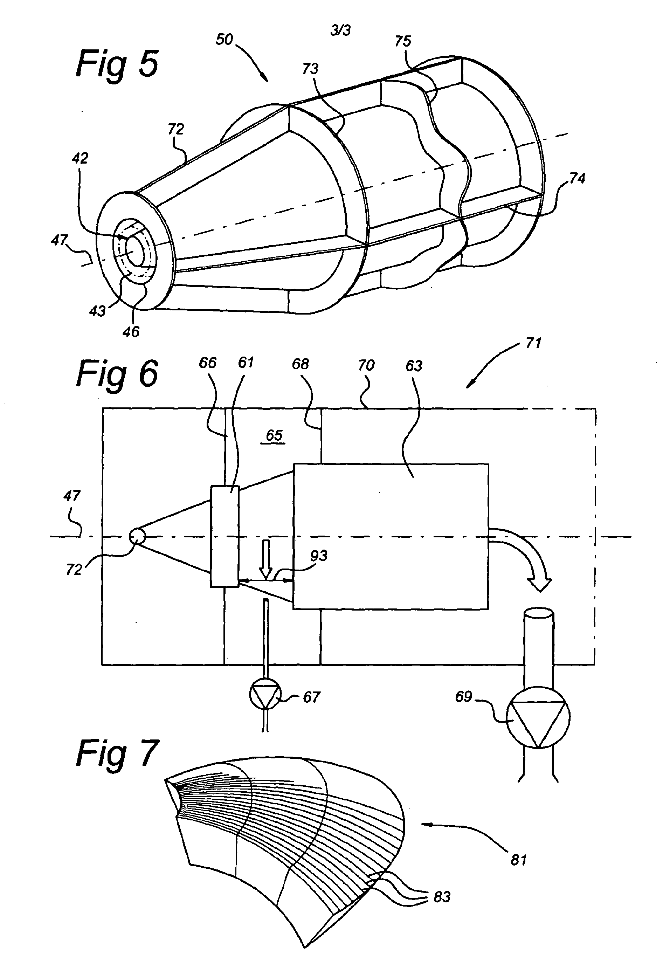

In Fig 5 a collector 50 is shown which has on its outer reflector 46 several radiation fins 72-75 attached. These radiation fins 72-75 may be arbitrarily distributed on the outer reflector 46. The radiation fins 72-75 may increase the heat/infrared "black body" reflecting properties of the collector 50 even further.

An improved vacuum separation between the EUV source and the optical components further along the optical axis may be achieved by using a collector that is part of a vacuum separation. This is realized by pumping the space that separates the collector from the other components in the lithographic projection apparatus. By using a reflector as described in German patent application no. DE 101 38 284.7, use is made of the relatively high flow resistance of the "onion-shell" type collector. The outside of the collector may form a vacuum barrier, while a pump may be employed immediately downstream of the reflector for pumping off residual gas passing through the collector at relatively low pumping rates such as 1mbar*1/s.
This will be described with reference to Fig. 6.

In the figure 6, part of an EUV illuminator 71 is shown. Reference numeral 61 indicates a channel array or foil trap. Due to the limited flow conductance of the channel array or foil trap 61, the pressure behind this array can be at least a 100 times lower than at the side of the EUV source 72, when a pump speed of several 1000 l/s can be reached behind the channel array 61. In view of the close distance of collector 63, this pump speed cannot be achieved by pump 67. A channel array 61 suitable for use in the present invention has been described in EP-A-1 223 468 and EP-A-1 057 079. Reference numeral 63 indicates a multi-shell grazing incidence EUV collector of the type as described in DE 101 38 284.7. These two components are connected via circumferential walls 66, 68 to housing 70 to constitute a vacuum chamber 65. The vacuum chamber 65 is evacuated by a pump 67. Due to the small separation 93 between the foil trap 61 and the grazing incidence EUV collector 63 of a few centimeters, which is kept as small as possible to limit the size of the EUV illuminator, the pump 67 will not be able to create a sufficient vacuum in the chamber 65 as the effective pump speed of pump 67 may be only a few 100 l/s. Therefore, a second pump 69 is arranged behind the grazing incidence EUV collector 63. The grazing incidence EUV collector 63 has a limited flow conductance such as 200 l/s. The pumps 67 and 69 together create the desired vacuum in the vacuum chamber 65, at a pump speed of several 100 l/s for pump 67 and several 1000 l/s for pump 69.

In Fig. 7 the detailed structure 81 of a part of the foil trap 61 is shown. The structure 81 consists of narrowly spaced slits or narrow elongated channels 83 which together form an open laminar structure. Also, the grazing incidence EUV collector 63 comprises, due to its onion like shell structure, open laminar channels.
Fig. 6 specifically relates to:
1. A lithographic projection apparatus (1) comprising:
   - an illumination system (3, 4) with a radiation source (6), to form a projection beam (6) of radiation,
   - a support structure (15) constructed to hold patterning means, to be irradiated by the projection beam to pattern said projection beam,
   - a substrate table (20) constructed to hold a substrate, and
   - a projection system (5) constructed and arranged to image an irradiated portion of the patterning means onto a target portion of the substrate.
   the projection apparatus further comprising:
   - a radiation source (72) placed on a optical axis (47),
   - a collector element (63) on said optical axis (47) comprising a number of concentric reflectors (42, 43, 46) placed in a housing comprising an outer side wall (70), a first transverse wall (66) being connected to the side wall (70) with one end and with another end to a channel array member (61), which channel array member (61) is placed on the optical axis (47),
   - a second transverse wall (68) connecting the circumference of the collector element (63) to the side wall (70) and forming a chamber (65),
   - a first pump element (67) connected to the first chamber (65) and
   - a second element (69) downstream of the collector element (63).
2. A lithographic projection apparatus (1) according to the previous paragraph 1 wherein the pump speed of the first pump (67) is in the range between 10 l/s and 5000 l/s, preferably in the range between 20 l/s and 2000 l/s, more preferably in the range between 50 l/s and 1000 l/s and that the pump speed of the second pump (69) is in the range between 10 l/s and 100000 l/s, preferably in the range between 900 l/s and 9000 l/s, more preferably in the range between 2000 l/s and 5000 l/s.

While specific embodiments of the invention have been described above, it will be appreciated that the invention may be practiced otherwise than as described. The description is not intended to limit the invention.

## Claims

1. A reflector assembly (10) comprising at least an inner (42) and an outer reflector ( 46), the reflectors (42, 46) each having an inner reflective surface (54) and an outer backing layer (52), the inner reflective surface (54) of the outer reflector (46) facing the backing layer (52) of the inner reflector (42), **characterized in that** the backing layer (52) of the inner reflector (42) is covered with a reflective layer (56) having a reflectivity of between 0,7 and 0,99 preferably between 0,8 and 0,99 for wavelengths between 1 and 10 µm.

2. A reflector assembly (10) comprising at least an inner (42) and an outer reflector ( 46), the reflectors (42, 46) each having an inner reflective surface (54) and an outer backing layer (52), the inner reflective surface (54) of the outer reflector (46) facing the backing layer (52) of the inner reflector (42), **characterized in that** the backing layer (52) of the outer reflector (46) being covered with a radiative layer (62) having an emissivity of between 0,7 and 0,99 preferably between 0,8 and 0,99 for wavelengths between 1 and 10 µm.

3. A reflector assembly (10) according to claim 2 wherein the backing layer (52) of the inner reflector (42) is covered with a reflective layer (56) having a reflectivity of between 0,7 and 0,99 preferably between 0,8 and 0,99 for wavelengths between 1 and 10 µm.

4. A reflector assembly (10) according to any of the claims 1, 2, or 3, wherein at least the outer reflector (46) comprises radiation fins (72-74).

5. A lithographic projection apparatus (1) comprising:
- an illumination system (3, 4) with a radiation source (6), to form a projection beam of radiation,
- a support structure (15) constructed to hold patterning means, to be irradiated by the projection beam to pattern said projection beam,
- a substrate table (20) constructed to hold a substrate, and
- a projection system (5) constructed and arranged to image an irradiated portion of the patterning means onto a target portion of the substrate,
the lithographic projection apparatus (1) further comprising:
- a reflector assembly (10) according to claim 1 placed in the vicinity of the source (6) or an image of said source.

6. A lithographic projection apparatus (1) comprising:
- an illumination system (3, 4) with a radiation source (6), to form a projection beam of radiation,
- a support structure (15) constructed to hold patterning means, to be irradiated by the projection beam to pattern said projection beam,
- a substrate table (20) constructed to hold a substrate, and
- a projection system (5) constructed and arranged to image an irradiated portion of the patterning means onto a target portion of the substrate,
the lithographic projection apparatus (1) further comprising:
- a reflector assembly (10) according to claim 2 placed in the vicinity of the source (6) or an image of said source.

7. A lithographic projection apparatus (1) according to claim 6 wherein the radiative layer comprises carbon (C).

8. A lithographic projection apparatus (1) according to claim 6 or 7 wherein the backing layer (52) of the inner reflector (42) is covered with a reflective layer (56) having a reflectivity of between 0,7 and 0,99 preferably between 0,8 and 0,99 for wavelengths (40) between 1 and 10 µm

9. A lithographic projection apparatus (1) according to claim 5 or 8 wherein the reflective layer comprises a noble metal

10. A lithographic projection apparatus (1) according to claim 9 wherein the noble metal comprises gold (Au) or ruthenium (Ru).

11. A lithographic projection apparatus (1) according to any of the claims 5 to 10, wherein the at least two reflectors (42, 43, 46) are substantially coaxial and extend substantially rotationally symmetric around the optical axis (47).

12. A lithographic projection apparatus (1) according to any of the claims 5 to 11 , wherein at least the outer reflector (46) of the reflectors (42, 43, 46) of the reflector assembly (10) comprises radiation fins.

## Patentansprüche

1. Reflektoranordnung (10), die zumindest einen inneren Reflektor (42) und einen äußeren Reflektor (46) aufweist, wobei die Reflektoren (42, 46) jeweils eine innere Reflexionsoberfläche (54) und eine äußere Trägerschicht (52) aufweisen,
wobei die innere Reflexionsoberfläche (54) des äußeren Reflektors (46) der Trägerschicht (52) des inneren Reflektors (42) gegenüberliegt,
**dadurch gekennzeichnet,**
**daß** die Trägerschicht (52) des inneren Reflektors (42) mit einer Reflexionsschicht (56) überzogen ist, die ein Reflexionsvermögen zwischen 0,7 und 0,99, vorzugsweise zwischen 0,8 und 0,99 für Wellenlängen besitzt, die zwischen 1 µm und 10 µm liegen.

2. Reflektoranordnung (10), die zumindest einen inneren Reflektor (42) und einen äußeren Reflektor (46) aufweist, wobei die Reflektoren (42, 46) jeweils eine innere Reflexionsoberfläche (54) und eine äußere Trägerschicht (52) aufweisen,
wobei die innere Reflexionsoberfläche (54) des äußeren Reflektors (46) der Trägerschicht (52) des inneren Reflektors (42) gegenüberliegt,
**dadurch gekennzeichnet,**
**daß** die Trägerschicht (52) des äußeren Reflektors (46) mit einer Strahlungsschicht (62) überzogen ist, die ein Emissionsvermögen zwischen 0,7 und 0,99, vorzugsweise zwischen 0,8 und 0,99 für Wellenlängen besitzt, die zwischen 1 µm und 10 µm liegen.

3. Reflektoranordnung (10) nach Anspruch 2,
wobei die Trägerschicht (52) des inneren Reflektors (42) mit einer Reflexionsschicht (56) überzogen ist, die ein Reflexionsvermögen zwischen 0,7 und 0,99, vorzugsweise zwischen 0,8 und 0,99 für Wellenlängen besitzt, die zwischen 1 µm und 10 µm liegen.

4. Reflektoranordnung (10) nach einem der Ansprüche 1,2 oder 3,
wobei zumindest der äußere Reflektor (46) Strahlungsrippen (72 - 74) aufweist.

5. Lithografische Projektionsvorrichtung,
die folgendes aufweist:
- ein Beleuchtungssystem (3, 4) mit einer Strahlungsquelle (6), um einen Projektionsstrahl der Strahlung zu bilden,
- eine Tragkonstruktion (15), die dazu ausgebildet ist, eine Strukturierungseinrichtung zu halten, die mit dem Projektionsstrahl zu bestrahlen ist, um den Projektionsstrahl zu strukturieren,
- einen Substrattisch (20), der dazu ausgebildet ist, ein Substrat zu halten, und
- ein Projektionssystem (5), das dazu ausgebildet und angeordnet ist, einen bestrahlten Bereich der Strukturierungseinrichtung auf einen Zielbereich des Substrats abzubilden,
wobei die lithografische Projektionsvorrichtung (1) ferner folgendes aufweist:
- eine Reflektoranordnung (10) gemäß Anspruch 1, die in der Nähe der Quelle (6) oder eines Bildes der Quelle angeordnet ist.

6. Lithografische Projektionsvorrichtung (1), die folgendes aufweist:
- ein Beleuchtungssystem (3, 4) mit einer Strahlungsquelle (6), um einen Projektionsstrahl der Strahlung zu bilden,
- eine Tragkonstruktion (15), die dazu ausgebildet ist, eine Strukturierungseinrichtung zu halten, die mit dem Projektionsstrahl zu bestrahlen ist, um den Projektionsstrahl zu strukturieren,
- einen Substrattisch (20), der dazu ausgebildet ist, ein Substrat zu halten, und
- ein Projektionssystem (5), das dazu ausgebildet und angeordnet ist, einen bestrahlten Bereich der Strukturierungseinrichtung auf einen Zielbereich des Substrats abzubilden,
wobei die lithografische Projetionsvorrichtung (1) ferner folgendes aufweist:
- eine Reflektoranordnung (10) gemäß Anspruch 2, die in der Nähe der Quelle (6) oder eines Bildes der Quelle angeordnet ist.

7. Lithografische Projektionsvorrichtung (1) nach Anspruch 6,
wobei die Strahlungsschicht Kohlenstoff (C) aufweist.

8. Lithografische Projektionsvorrichtung (1) nach Anspruch 6 oder 7,
wobei die Trägerschicht (52) des inneren Reflektors (42) mit einer Reflexionsschicht (56) überzogen ist, die ein Reflexionsvermögen zwischen 0,7 und 0,99, vorzugsweise zwischen 0,8 und 0,99 für Wellenlängen besitzt, die zwischen 1 µm und 10 µm liegen.

9. Lithografische Projektionsvorrichtung (1) nach Anspruch 5 oder 8,
wobei die Reflexionsschicht ein Edelmetall aufweist.

10. Lithografische Projektionsvorrichtung (1) nach Anspruch 9,
wobei das Edelmetall Gold (Au) oder Ruthenium (Ru) aufweist.

11. Lithografische Projektionsvorrichtung (1) nach einem der Ansprüche 5 bis 10,
wobei die mindestens zwei Reflektoren (42, 43, 46) im wesentlichen koaxial angeordnet sind und sich im wesentlichen rotationssymmetrisch um die optische Achse (47) erstrecken.

12. Lithografische Projetionsvorrichtung (1) nach einem der Ansprüche 5 bis 11,
wobei zumindest der äußere Reflektor (46) der Reflektoren (42, 43, 46) der Reflektoranordnung (10) Strahlungsrippen aufweist.

## Revendications

1. Ensemble réflecteur (10) comprenant au moins un réflecteur interne (42) et un réflecteur externe (46), les réflecteurs (42, 46) comportant chacun une surface réfléchissante interne (54) et une couche de support externe (52), la surface réfléchissante interne (54) du réflecteur externe (46) faisant face à la couche de support (52) du réflecteur interne (42), **caractérisé en ce que** la couche de support (52) du réflecteur interne (42) est recouverte d'une couche réfléchissante (56) présentant une réflectivité comprise entre 0,7 et 0,99, de préférence entre 0,8 et 0,99 pour des longueurs d'ondes comprises entre 1 et 10 µm.

2. Ensemble réflecteur (10) comprenant au moins un réflecteur interne (42) et un réflecteur externe (46), les réflecteurs (42, 46) comportant chacun une surface réfléchissante interne (54) et une couche de support externe (52), la surface réfléchissante interne (54) du réflecteur externe (46) faisant face à la couche de support (52) du réflecteur interne (42), **caractérisé en ce que** la couche de support (52) du réflecteur externe (46) est recouverte d'une couche radiative (62) présentant une émissivité comprise entre 0,7 et 0,99, de préférence entre 0,8 et 0,99 pour des longueurs d'ondes comprises entre 1 et 10 µm.

3. Ensemble réflecteur (10) selon la revendication 2, dans lequel la couche de support (52) du réflecteur interne (42) est recouverte d'une couche réfléchissante (56) présentant une réflectivité comprise entre 0,7 et 0,99, de préférence entre 0,8 et 0,99 pour des longueurs d'ondes comprises entre 1 et 10 µm.

4. Ensemble réflecteur (10) selon l'une quelconque des revendications 1, 2 ou 3, dans lequel au moins le réflecteur externe (46) comprend des ailettes de rayonnement (72-74).

5. Appareil de projection lithographique (1) comprenant :
- un système d'éclairage (3, 4) avec une source de rayonnement (6), pour former un faisceau de projection de rayonnement,
- une structure de support (15) construite de manière à maintenir un dispositif de formation de motifs, devant être irradié par le faisceau de projection pour former des motifs sur ledit faisceau de projection,
- une table à substrat (20) construite de manière à maintenir un substrat, et
- un système de projection (5) construit et conçu de manière à imager une partie irradiée du dispositif de formation de motifs sur une partie cible du substrat, l'appareil de projection lithographique (1) comprenant en outré :
- un ensemble réflecteur (10) selon la revendication 1 placé dans le voisinage de la source (6) ou d'une image de ladite source.

6. Appareil de projection lithographique (1) comprenant :
- un système d'éclairage (3, 4) avec une source de rayonnement (6), pour former un faisceau de projection de rayonnement,
- une structure de support (15) construite de manière à maintenir un dispositif de formation de motifs, devant être irradié par le faisceau de projection pour former des motifs sur ledit faisceau de projection,
- une table à substrat (20) construite de manière à maintenir un substrat, et
- un système de projection (5) construit et conçu de manière à imager une partie irradiée du dispositif de formation de motifs sur une partie cible du substrat, l'appareil de projection lithographique (1) comprenant en outré :
- un ensemble réflecteur (10) selon la revendication 2 placé dans le voisinage de la source (6) ou d'une image de ladite source.

7. Appareil de projection lithographique (1) selon la revendication 6, dans lequel la couche radiative comprend du carbone (C).

8. Appareil de projection lithographique (1) selon la revendication 6 ou 7, dans lequel la couche de support (52) du réflecteur interne (42) est recouverte d'une couche réfléchissante (56) présentant une réflectivité comprise entre 0,7 et 0,99, de préférence entre 0,8 et 0,99 pour des longueurs d'ondes (40) comprises entre 1 et 10 µm.

9. Appareil de projection lithographique (1) selon la revendication 5 ou 8, dans lequel la couche réfléchissante comprend un métal noble.

10. Appareil de projection lithographique (1) selon la revendication 9, dans lequel le métal noble comprend de l'or (Au) ou du ruthénium (Ru).

11. Appareil de projection lithographique (1) selon l'une quelconque des revendications 5 à 10, dans lequel les au moins deux réflecteurs (42, 43, 46) sont sensiblement coaxiaux et s'étendent sensiblement symétriques en rotation autour de l'axe optique (47).

12. Appareil de projection lithographique (1) selon l'une quelconque des revendications 5 à 11, dans lequel au moins le réflecteur externe (46) des réflecteurs (42, 43, 46) de l'ensemble réflecteur (10) comprend des ailettes de rayonnement.
